# EUROPEAN PATENT SPECIFICATION

(11) **EP 3 235 016 B1**
(45) Date of publication and mention of the grant of the patent: **17.04.2019**
(21) Application number: 15819807.7
(22) Date of filing: 17.12.2015
(51) Int. Cl.: H01L 41/18, C09J 4/00

(54) **A FERROELECTRIC ADHESIVE COMPOSITION**
FERROELEKTRISCHE KLEBSTOFFZUSAMMENSETZUNG
COMPOSITION ADHÉSIVE FERROÉLECTRIQUE

(30) Priority: 17.12.2014 US 201462093126 P; 24.07.2015 US 201562196379 P
(43) Date of publication of application: 25.10.2017
(73) Proprietor: Henkel AG & Co. KGaA, 40589 Düsseldorf (DE); Henkel IP & Holding GmbH, 40589 Düsseldorf (DE)
(72) Inventor: GARCIA MIRALLES, Jose, 40217 Düsseldorf (DE); SALHI, Fouad, 08195 Sant Cugat (Barcelona) (ES); RODRIQUEZ, Jaime, 28044 Madrid (ES); LIMA, Jorge, 1040 Bruxelles (BE); PINA-ROMERO, Beatriz, 08940 Cornella de Llobregat (ES); CARRERAS SEGUI, Paz, 08029 Barcelona (ES); MARQUET, Jordi, 08034 Barcelona (ES); SEBASTIAN, Rosa Maria, 08291 Ripollet Barcelona (ES); MENDIZABAL ZALAKIN, Julen, 08029 Barcelona (ES)
(74) Representative: Henkel IP Department
(86) International application number: PCT/EP2015/080130
(87) International publication number: WO 2016/097077

(56) References cited:
- WO-A1-2014/162976
- DE-A1- 10 104 605

## Description

### Technical field

The present invention relates to a ferroelectric adhesive composition. The composition according to the present invention has high adhesive properties and while maintaining good ferroelectric response.

### Background of the invention

Ferroelectricity is defined as the property of certain materials to show a permanent remnant polarization (Pr) when an electric field is removed below a certain temperature called Curie Temperature (Tc). Moreover, this polarization can be reversed by the application of an electric field in the proper direction. These materials show a hysteretic behavior under a variable electric field, typical from non-linear systems. The polarization can be cancelled when a certain electric field is applied in the opposite direction, known as Coercive Field (Ec).

Currently, applications in which ferroelectric materials are required, use ferroelectric ceramics or ferroelectric polymers. The latter show very low adhesive properties, while the former have no adhesion properties at all. Therefore, if these materials have to be fixed permanently to any substrate, they have to be attached using separate adhesive.

Above described materials are both piezoelectric and pyroelectric, which means they can be deformed or heated under the effect of an electric field. These processes are reversible as well, deformations or changes in the temperature generate an electrical output. Therefore, these materials are interesting in sensor applications (voltage variations are monitored) or energy harvesting applications (turning residual mechanical energy into useful electrical energy). On the other hand, as these materials are shape-sensitive to electric fields, they are commonly used for transducer applications, generating mechanical waves when under AC field.

Up to date, piezoelectric elements have been incorporated into adhesive resins with different objectives. Two main approaches have been found to be the most common; composites with ferroelectric ceramics and combination of ferroelectric and non-ferroelectric polymers.

Ferroelectric ceramics have been mixed with polymeric resins resulting in composite materials. This approach is widely used and very well known, nevertheless, in most cases, the polymeric resin is not used due to its adhesive properties but rather as a binder. By doing this, the mechanical properties (too brittle) and the processability of the ferroelectric systems (difficult to process in general) are improved.

Improvement in the processing of piezoelectric ceramics has been done by preparing 0-3 composites, which can be cast or applied like paints. These composites contain a fluorinated polymer, and from 40% to 60% volume fraction of PZT piezoelectric particles, and are cured and poled (3-5 kV/mm for 10 minutes) prior to evaluating the piezoelectric properties. These composites have a piezoelectric coefficient (d₃₃) around 30 pC/N.

Alternatively, an epoxy resin has been used as binder in PZT/epoxy piezoelectric paints. These composite paints have been processed into films, which are then attached from one side in order to act like piezoelectric sensors in NDT applications, where vibration detection is required.

Alternatively, the piezoelectric and pyroelectric properties of the dispersed particles have been used to heat the matrix under an electric field, thus providing an alternative method for curing the adhesive resin.

In one study, piezoelectricity is provided either by the adhesive matrix itself (which shows very low response) or by a dispersion of piezoelectric particles, filling up to 30% in volume fraction (which provides a higher piezoelectric contribution). The piezoelectric response of the system, with and without particle filling, is then related to the expected adhesive performance of the system. These composites use an epoxy resin as a matrix and quartz particles as piezoelectric particles. Using these composites themselves as a sensor, the reliability of an adhered structural joint is monitored by reading the charge generated in the adhesive due to the induced stress during a fatigue experiment. A sudden increase in charge is detected when delamination occurs (due to reduction of the adhered surface).

Alternatively, polymeric coatings using specific fluoropolymers as part of the composition have been developed. However, in these compositions, the fluoropolymers are not used due their ferroelectric properties but their chemical resistance properties. And therefore, fluoropolymers are not in the ferroelectric phase in these coating compositions. It is well known that fluoropolymer-based ferroelectric polymers have dielectric properties, but also outstanding barrier properties. Those come from their chemical nature, making them very inert materials. Nevertheless, this property hinders the adhesion to the substrates, and in order to fulfil the coating requirements, it is necessary to incorporate an alternative resin to improve adhesion properties.

Ferroelectric materials are also widely used in industry as receiver sensors (accelerometers, gyroscopes, shock wave sensors, impact sensors, stress-strain sensors and receiver transducers) and as emitters (level sensors, ultrasonic distance sensors, flow rate measurement sensors, transducers for Non Destructive Evaluation-SHM, sonar, hydrophones, for high intensity ultrasonic cleaning, for high intensity ultrasonic welding and as actuators).

Another important field in which ferroelectrics are widely used is in medical diagnosis (ultrasonic scan) and as medical tools (surgical knives, bubble detectors, aerosol production for inhalers, shock wave lithotripsy or as a cleaning tool).

Some examples in consumer markets are speakers, pick-ups for instruments, microphones, lighters, keypads, printers, and the newly developed energy harvesters. Examples of prior art may be found in patent documents DE10104605 and WO2014/162976.

As stated above all these applications are made using ferroelectric ceramics or polymers, which are then attached by using separate adhesives. An adhesive with ferroelectric properties would simplify the processing and improve the quality of the systems since interfaces would be avoided.

Therefore there is a need for a ferroelectric adhesive composition, which adhere to the substrate on its own without using separate adhesive to adhere it and is able to act as a structural adhesive having a good adhesion strength, while providing good ferroelectric response.

### Short description of the figures

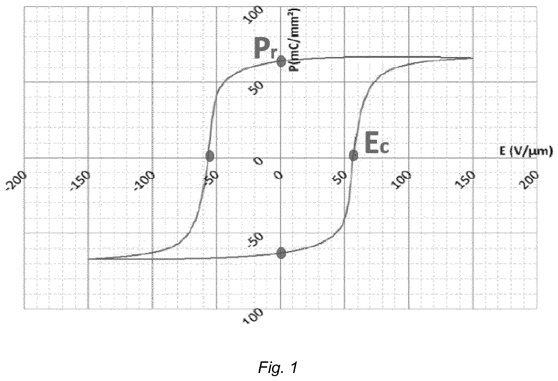

Figure 1 illustrates typical hysteresis loop of a commercial ferroelectric polymer film.

### Summary of the invention

The present invention relates to a ferroelectric adhesive composition comprising from 3 to 30 % of an adhesive matrix, from 5 to 85 % of a ferroelectric component, and from 30 to 90 % of a solvent, wherein all weight percentages are based on weight of the total weight of the composition, and wherein said ferroelectric component is in a ferroelectric phase.

In addition, the present invention relates to use of a ferroelectric adhesive composition according to the present invention as a structural adhesive.

The present invention also encompasses use of a ferroelectric adhesive composition according to the present invention as a sensor, an emitter or as a generator in energy harvester.

Furthermore, the present invention also encompasses a device comprising a ferroelectric adhesive composition according to the present invention between two conductive elements.

### Detailed description of the invention

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous. In the context of the present invention, the terms used are to be construed in accordance with the following definitions, unless a context dictates otherwise.

As used herein, the singular forms "a", "an" and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps.

The recitation of numerical end points includes all numbers and fractions subsumed within the respective ranges, as well as the recited end points.

When an amount, a concentration or other values or parameters is/are expressed in form of a range, a preferable range, or a preferable upper limit value and a preferable lower limit value, it should be understood as that any ranges obtained by combining any upper limit or preferable value with any lower limit or preferable value are specifically disclosed, without considering whether the obtained ranges are clearly mentioned in the context.

Unless otherwise defined, all terms used in the disclosing the invention, including technical and scientific terms, have the meaning as commonly understood by one of the ordinary skill in the art to which this invention belongs to. By means of further guidance, term definitions are included to better appreciate the teaching of the present invention.

The present invention provides a structural adhesives, which are provided with ferroelectric properties. Ferroelectric-adhesion system is simplified in a single material (adhesive composition). An adhesive composition with ferroelectric properties will simplify the system and will improve its quality since interfaces, which are mechanically weak regions and source of defects, will be avoided.

The present invention provides adhesives with ferroelectric properties and on the other hand the present invention provides ferroelectric material with adhesive properties. Ferroelectric response and piezoelectricity of ferroelectric adhesive compositions according to the present invention are demonstrated.

The present invention provides a ferroelectric adhesive composition comprising a) from 3 to 30 % of an adhesive matrix, b) from 5 to 85 % of a ferroelectric component, and c) from 30 to 90 % of a solvent wherein all weight percentages are based on weight of the total weight of the composition, and wherein said ferroelectric component is in a ferroelectric phase.

The ferroelectric adhesive composition according to the present invention shows high adhesive and ferroelectric properties.

Each of the essential components of the ferroelectric adhesive composition according to the present invention are described in details below.

### An adhesive matrix

A ferroelectric adhesive composition according to the present invention comprises an adhesive matrix. The adhesive matrix used in the ferroelectric adhesive composition may be selected from any adhesive currently used in the industry, however, the adhesive matrix must be compatible with used ferroelectric component in order to avoid or decrease to the minimum undesired phase separation between them. The suitable ferroelectric component must be intimately/finely dispersed into the adhesive matrix. Furthermore, suitable adhesive matrix must be resistant to an electric field, due the fact that electric field is applied to the composition when poling is done.

By the term 'adhesive matrix' is meant herein an adhesive or a resin or a binder, which is surrounding the ferroelectric component and binding the ferroelectric components together and keeping them in the ferroelectric phase, and furthermore, providing adhesion needed between the surfaces to be bonded.

Suitable adhesive matrix for use in the present invention is preferably selected from the group consisting of hotmelt adhesives, thermoplastics, one or two component polyurethanes, one or two component polyepoxides, (meth)acrylates, cyanoacrylates and mixtures thereof.

In one embodiment a ferroelectric adhesive is a ferroelectric hotmelt adhesive. In one embodiment a ferroelectric adhesive is a ferroelectric thermoset adhesive. In another embodiment a ferroelectric adhesive is a ferroelectric one or two component polyurethane adhesive. Yet, in another embodiment, a ferroelectric adhesive is a ferroelectric (meth)acrylate adhesive. Yet, in another embodiment, a ferroelectric adhesive is a ferroelectric cyanoacrylate adhesive.

Suitable acrylate and methacrylate resins for use in the present invention are selected from aliphatic, cycloaliphatic, and aromatic acrylates and methacrylates.

Furthermore, specific reactive (meth)acrylate monomers for use in the present invention include, but are not limited to, triethylene glycol dimethacrylate (TGM), alkoxylated hexanediol di(meth)acrylate, trimethylolpropane tri(meth)acrylate, tricyclodecane dimethanol diacrylate, dicyclopentadienyl methacrylate, ethoxylated bisphenol A di(meth)acrylate, tris (2-hydroxy ethyl) isocyanurate triacrylate, polybutadiene urethane dimethacrylate and polybutadiene dimethacrylate and epoxy acrylate resins, which are all commercially available from Sartomer Company, Inc.

Other suitable reactive (meth)acrylate monomers for use in the present invention include, but are not limited to, 2-[3-(2H-benzotriazol-2-yl)-4-hydroxyphenyl]ethyl methacrylate, 2-(diethylamino)ethyl acrylate, 2-N-morpholinoethyl methacrylate, 2-(dimethylamino)ethyl methacrylate, 2-(diethylamino)ethyl methacrylate, ethyl 3-(2-amino-3-pyridyl)-acrylate, (E)-methyl 3-(2-arnino-5-methylpyridin-3-yl)acrylate, methyl 3-(2-amino-4-methoxypyridin-3-yl)acrylate, which are all commercially available from Aldrich.

And further suitable reactive monomers for use in the present invention include, but are not limited to, hydroxypropyl methacrylate (HPMA), hydroxyethylmethacrylate (HEMA), tetrahydrofurfuryl acrylate, zinc acrylate, butyl (meth)acrylate, isobutyl (meth)acrylate, 2-ethyl hexyl (meth)acrylate, isodecyl (meth)acrylate, n-lauryl (meth)acrylate, alkyl (meth)acrylate, tridecyl(meth)acrylate, n-stearyl (meth)acrylate, cyclohexyl(meth)acrylate, tetrahydrofurfuryl-(meth)acrylate, 2-phenoxy ethyl(meth)acrylate, isobornyl(meth)acrylate, 1,4-butanediol di(meth)acrylate, 1,6-hexanediol di(meth)acrylate, 1,9-nonandiol di(meth)acrylate, perfluorooctylethyl (meth)acrylate, 1,10-decandiol di(meth)acrylate, nonylphenol polypropoxylate (meth)acrylate, and polypentoxylate tetrahydrofurfuryl acrylate, which are all commercially available from Kyoeisha Chemical Co.

Additional suitable reactive (meth)acrylate monomers for use in the present invention include polycarbonate urethane diacrylate available from Negami Chemical Industries Co., LTD; acrylated aliphatic urethane oligomers available from Radcure Specialities, Inc; and polyester acrylate oligomers available from Radcure Specialities, Inc..

Suitable maleimide resins for use in the present invention include, but are not limited to, N-butylphenyl maleimide and N-ethylphenyl maleimide.

Other suitable maleimide resins are those having the formulas I - IV below.

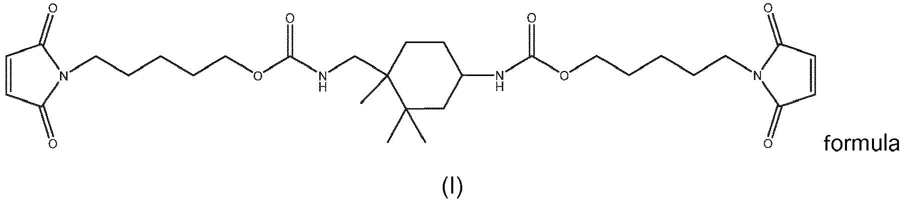

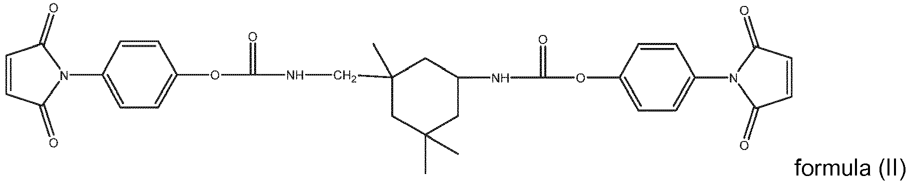

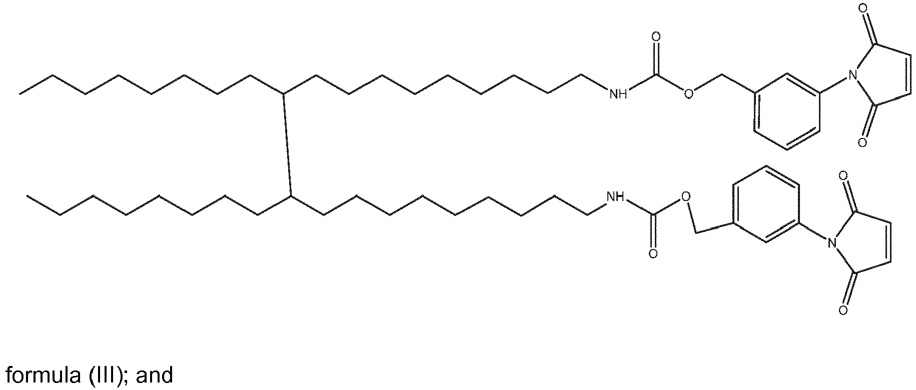

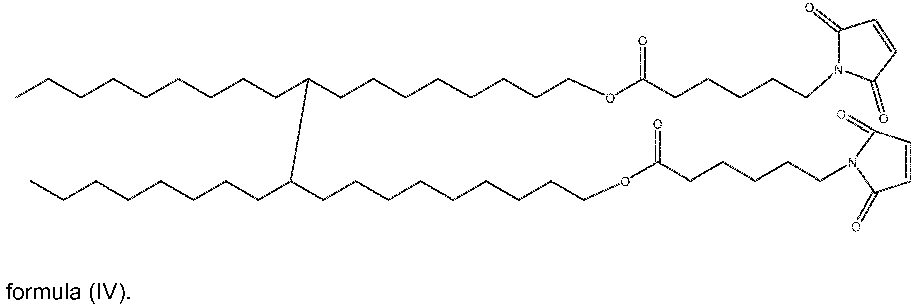

Suitable epoxy resins for use in the present invention are selected from aliphatic, cycloaliphatic, and aromatic epoxy resins.

Suitable cycloaliphatic epoxy resins for use in the present invention include include 3,4-epoxycyclohexylmethyl-3,4-epoxycyclohexane carboxylate, bis(3,4-epoxycyclohexylmethyl) adipate and 1,2-epoxy-4-(2-oxiranyl)-cyclohexane with 2,2-bis(hydroxymethyl)-1-butanol.

Suitable multifunctional aromatic epoxy resins for use in the present invention include include, but are not limited to, monofunctional and multifunctional glycidyl ethers of Bisphenol-A and Bisphenol-F, 2,6-(2,3-epoxypropyl) phenylglycidyl ether, polyglycidyl ethers of phenol-formaldehyde novolac resins, tetraglycidyl 4,4'-diamino diphenyl methane, epoxy novolac resin (such as, poly(phenyl glycidyl ether)-co-formaldehyde), biphenyl epoxy resin (prepared by the reaction of biphenyl resin and epichlorohydrin), dicyclopentadiene-phenol epoxy resin, epoxy naphthalene resins, and epoxy functional butadiene acrylonitrile copolymers.

Other suitable epoxies for use in the present invention include 3,4-epoxycyclohexylmethyl-3,4-epoxycyclohexane carboxylate, which contains two epoxide groups that are part of the ring structures and an ester linkage; vinylcyclohexene dioxide, which contains two epoxide groups, one of which is part of the ring structure; 3,4-epoxy-6-methyl cyclohexyl methyl-3,4-epoxycyclohexane carboxylate; and dicyclopentadiene dioxide.

Suitable oxetane resins for use in the present invention are selected from aliphatic, cycloaliphatic, and aromatic oxetane resins.

Suitable oxetane compounds for use in the present invention include 3-methyl-3-hydroxymethyloxetane, 3-ethyl-3-hydroxy-methyloxetane, 3-methyl-3-bromomethyloxetane, 3-ethyl-3-bromomethyloxetane, 3-methyl-3-alkylbromomethyloxetane, 3-ethyl-3-alkylbromomethyloxetane, 3-methyl-3-tosylmethyloxetane and 3-ethyl-3-tosylmethyl-oxetane.

Other suitable oxetane compounds for use in the present invention include those prepared from 3-ethyl-3-(hydroxy methyl) oxetane and a co-reactive compound obtained as follows: the reaction of 3-ethyl-3-(hydroxymethyl) oxetane with m-tetramethyl-xylene-diisocyanate to give the compound having a formula (V) 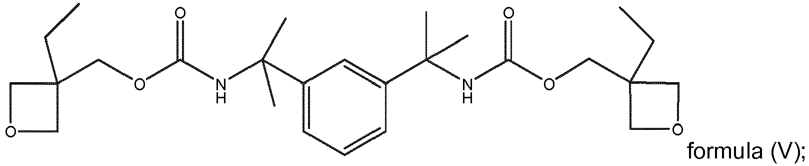 the reaction of 3-ethyl-3-(hydroxymethyl) oxetane with azelaoyl chloride to give the compound having formula (VI) 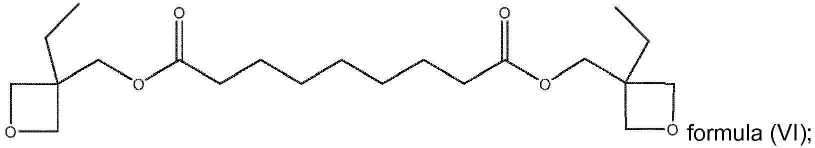 the reaction of 3-ethyl-3-(hydroxymethyl) oxetane with terephthaloyl chloride to give the compound having formula (VII) 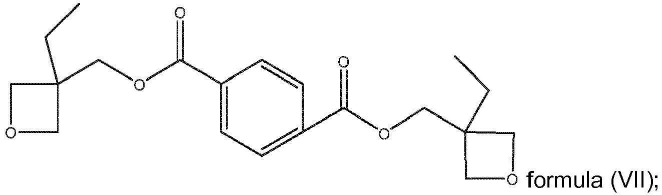 and the reaction of 3-ethyl-3-(hydroxymethyl) oxetane with 1,3,5-benzene-tricarbonyl trichloride to give the compound having formula (VIII)

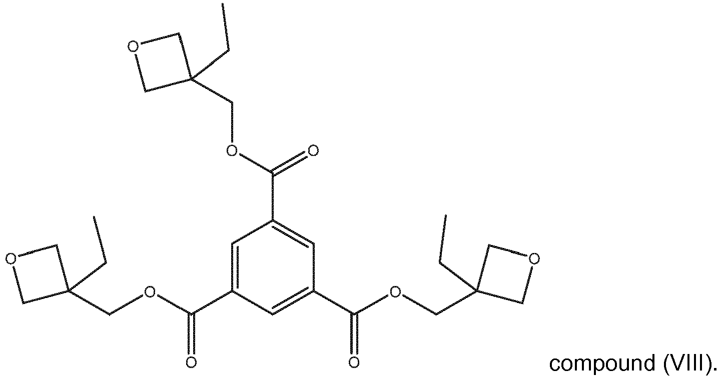

Suitable polyurethanes for use in the present invention are polyurethane prepolymers with free isocyanate groups, prepared by reacting at least one polyol selected from the group consisting of polyether polyols, polyester polyols, and mixtures thereof with at least one polyisocyanate in stoichiometric excess.

Suitable polyisocyanates for use in the present invention to form polyurethanes can be selected from the group consisting of 1,5-diisocyanate naphthalene, 4,4'-diphenylmethane diisocyanate (MDI), 2,4'-diphenylmethane diisocyanate, 2,2'- diphenylmethane diisocyanate, hydrogenated or partially hydrogenated MDI (H12MDI, H6MDI), xylene diisocyanate (XDI), meta-tetramethylxylylene diisocyanate (TMXDI), di- and tetraalkylene diphenylmethandiisocyanate, 4,4'-dibenzyldiisocyanate, 1,3-phenylendiisocyanate, 1,4-phenylene diisocyanate, isomers of toluene diisocyanate (TDI), 1-methyl-2,4-diisocyanate cyclohexane, 1,6-diisocyanate-2,2,4-trimethylhexane, isophorone diisocyanate (IPDI), 4,4'-dicyclohexylmethane diisocyanate (H12MDI), chlorinated and brominated diisocyanates, phosphorus-containing diisocyanates, tetramethoxybutan-1, naphthalene 1,5-diisocyanate (NDI), 1,4-diisocyanate butane, 1,6 hexamethylene diisocyanate (HDI), dicyclohexylmethane diisocyanate, 2,2,4-trimethyl-hexan-2,3,3-trimethyl-hexamethylendiisocyanate, 1,4-diisocyanate cyclohexane, 1,3-diisocyanate cyclohexane, diisocyanate ethylene, methylenetriphenyl triisocyanate (MIT), phthalic acid-bis-isocyanatoethyl ester, diisocyanates comprising reactive halogen atoms such as 1-chloro-methylphenyl-2,4-diisocyanate, 1-bromomethyl-phenyl-2,6-diisocyanate and 3,3-bis-chloro-methyl-4,4'-diphenyl diisocyanate. Other suitable diisocyanates are trimethyl hexamethylene diisocyanate, 1,4-diisocyanatobutane, 1,12-diisocyanato-dodecane and dimerfattyacid diisocyanate, lysine diisocyanate.

Suitable polyether polyols for use in the present invention to form polyurethanes are reaction products of low molecular weight polyhydric alcohols with alkylene oxides. The alkylene oxides have preferably from 2 to 4 carbon atoms. Suitable examples are the reaction products of ethylene glycol, propylene glycol, isomeric butane, hexanediols, 4,4'-dihydroxy-diphenyl ethylene oxide, propylene oxide, butylene oxide or mixtures of two or more thereof. Furthermore, the reaction products of polyfunctional alcohols such as glycerin, tri-methylolethan or trimethylolpropane, pentaerythritol or sugar alcohols with the alkylene oxides to form polyether polyols are also suitable. Further suitable polyols in the present invention are formed by polymerization of tetrahydrofuran (poly-THF). These polyether polyols are prepared in the conventional manners and are commercially available.

Among the polyether polyols mentioned above, the reaction products of low molecular weight alcohols with propylene oxide under conditions in which some of secondary hydroxyl groups are formed are also particularly suitable.

For example, suitable are polyether polyols having a molecular weight of from 200 to 5000 g/mol, preferably from 400 to 4000 g/mol (number average molecular weight (Mn) is measured by GPC according to DIN 55672-1: 2007-08). This corresponds to hydroxyl (OH numbers, determined to DIN 53240-2: 2007-11) 560-22 mg KOH/g, preferably from 280 to 28 mg KOH/g at bifunctional polyether polyols. Preferred polyols are, in the molecule 2 or 3 OH groups, in particular diols having hydroxyl numbers between 20 and 500 mg KOH/g.

Furthermore, polyester polyols are suitable for use in the present invention to form polyurethanes. Such polyester polyols preferably include the reaction products of polyhydric, preferably dihydric alcohols, optionally together with small amounts of polyfunctional trifunctional alcohols, and, preferably difunctional and/or trifunctional carboxylic acids. Instead of free polycarboxylic acids, the corresponding polycarboxylic anhydrides or corresponding polycarboxylic acid esters with alcohols preferably having from 1 to 3 carbon atoms can be used. Suitable for preparation of such polyester polyols are, in particular hexanediol, butanediol, propanediol, ethylene glycol, 1,4-hydroxymethylcyclohexane, 2-methyl-1,3-propanediol, triethylene glycol, tetraethylene glycol, polyethylene glycol, dipropylene glycol, polypropylene glycol, dibutylene, and mixtures of such alcohols.

The polyester polyols to be employed according to the invention include preferably the reaction products of polyhydric, preferably dihydric alcohols, optionally together with small amounts of polyfunctional trifunctional alcohols, and preferably, difunctional and/or trifunctional carboxylic acids. Instead of free polycarboxylic acids, the corresponding polycarboxylic anhydrides or corresponding polycarboxylic acid esters with alcohols preferably having 1 to 3 carbon atoms can be used.

Suitable for preparation of such polyester polyols are, in particular hexanediol, butanediol, propanediol, ethylene glycol, 1,4-hydroxymethylcyclohexane, 2-methyl-1,3-propanediol, triethylene glycol, tetraethylene glycol, polyethylene glycol, dipropylene glycol, Polypropylenglykol, dibutylene, and mixtures of such alcohols.

The polycarboxylic acids may be aliphatic, cycloaliphatic, aromatic or heterocyclic or both. They may optionally be substituted, for example by alkyl groups, alkenyl groups, ether groups or halogens. Suitable polycarboxylic acids such as succinic acid, adipic acid, suberic acid, azelaic acid, sebacic acid, phthalic acid, isophthalic acid, terephthalic acid, trimellitic acid, phthalic anhydride, tetrahydrophthalic anhydride, hexahydrophthalic anhydride, glutaric anhydride, maleic acid, maleic anhydride, fumaric acid, dimer fatty acid or trimer fatty acid or mixtures of two or more of these are suitable. As tricarboxylic acids include citric acid and trimellitic preferably suitable. The acids mentioned may be used individually or as mixtures of two or more of them. Especially suitable are two or three terminal OH-group-containing polyester polyols.

Particularly suitable polyester polyols for the production of polyurethanes for use in the present invention are liquid, amorphous or crystalline copolyester or mixtures thereof, such polyester polyols are provided, for example, under the name Dynacoll from Evonik Industries AG. Preferably, these polyester polyols have a hydroxyl (determined according to DIN 53240-2: 2007-11) between 10 and 200 mg KOH/g and an acid number (determined according to DIN EN ISO 2114 Corrigendum 1: 2006-11), which is less than or equal to 4, preferably less than or equal to 2 mg KOH/g.

Suitable cyanoacrylate monomers for use in the present invention include, but are not limited to, ethyl-2-cyanoacrylate, n-butyl cyanoacrylate, 2-octyl cyanoacrylate, methyl 2-cyanoacrylate, β-methoxyethyl cyanoacrylate, isobutyl cyanoacrylate, β-ethoxyethyl cyanoacrylate, 2-ethylhexyl cyanoacrylate, 2-phenylethyl cyanoacrylate, cyclohexenyl cyanoacrylate, neopentyl cyanoacrylate, octadecyl cyanoacrylate, propargyl cyanoacrylate, tetrahydrofurfuryl cyanoacrylate.

Suitable commercially available adhesive matrix material to be used in the present invention are for example CN1963 from Sartomer, Epikote 232 from Momentive and D.E.R 331 from Dow Chemicals.

A ferroelectric adhesive composition according to the present invention comprises an adhesive matrix from 3 % to 30 % and preferably from 4 % to 28 %. The quantity of the adhesive matrix in the composition according to the present invention is ideal, because higher quantities would interfere negatively with the ferroelectric properties leading to a composition having no ferroelectric response at all or very poor ferroelectric response. In addition, lower levels (less than 2.0 % by weight of the total weight of the composition) would decrease the adhesion properties of the ferroelectric adhesive composition.

### A ferroelectric component

A ferroelectric adhesive composition according present invention comprises an organic or inorganic ferroelectric component, which is in the ferroelectric phase.

By the term "ferroelectric phase" is meant herein that the material contains a certain amount of crystalline phase, which is in a specific symmetry, which is responsible of providing ferroelectric response.

The skilled person knows how to determine whether the component is in the ferroelectric phase or not by doing standard measurements by using x-ray diffraction or differential scanning calorimetry (DSC) or Fourier-transformed infra-red (FTIR). Alternatively, ferroelectric phase can be determined by measuring the ferroelectric response of the material. Meaning that if the composition is not in the ferroelectric phase, there will not be ferroelectric response either.

Ferroelectric component provides novel properties for the adhesives, more specifically for structural adhesives. Under an electric field, polarization is controlled and changes in shape (piezoelectricity) and in temperature (pyroelectricity) are induced. These properties also work the other way around: changes in shape, temperature and polarization generate an electrical output.

Ferroelectric components are characterized by their hysteretic polarization behaviour when an electric field is applied (figure 1) and they are below a certain temperature, called Curie Temperature (T_{c}). Initially, they are polarized under the effect of an electric field like any dielectric material, however, when the electric field is removed a certain polarization remains (Pr) making these materials unique. This remnant polarization can be oriented at will depending on the direction of the electric field applied, thus creating two differentiated states (dipoles "up" and dipoles "down").

Figure 1 illustrates the ferroelectric hysteresis loop of a commercial copolymer film. Ferroelectric components are characterized by showing net polarization although they are not subjected to an electrical stimulus (Pᵣ). Another relevant feature is the coercive electric field (E_{c}), which is defined as the required electric field, which must be applied to make the polarization of the system go to zero. In contrast to these materials, a typical dielectric material does not show any net polarization unless an electric field is applied, and the E_{c} is always zero.

Once the ferroelectricity of a material is verified after obtaining the ferroelectric hysteresis loop, poling must be carried out in order to have high ferroelectric response. Poling consists on applying a high electric field for a specific time at a specific temperature in order to orient all dipoles in the same direction. The electric field applied has to be higher than the Ec. This step is critical as high electric fields applied for longer times can induce electrical breakdown in the sample if it presents any defect.

The ferroelectric component comprises a ceramic powder or a polymer, which may be or may not be dissolved and may have a treated surface. Suitable organic ferroelectric components for use in the present invention show a Tc between 110°C and 170°C. In addition, suitable ferroelectric component for use in the present invention must be compatible with selected adhesive matrix in order to avoid undesired phase separation between them.

Type and quantity of the ferroelectric component have an effect on the ferroelectric response of the adhesive composition.

Suitable organic ferroelectric component for use in the present invention is selected from the group consisting of polyvinylidene difluoride (PVDF), polyvinylidene difluoride trifluoroethylene (P(VDF-TrFE)), polyvinylidene difluoride hexafluoropropylene (P(VDF-HFP)), polyvinylidene difluoride trifluoroethylene chlorofluoroethylene (P(VDF-TrFE-CFE)) 2-methylbenzimidazole, diisopropylammonium chloride, diisopropylammonium bromide, croconic acid, TTF-PMDI salts and mixtures thereof, preferably said organic ferroelectric component is polyvinylidene difluoride trifluoroethylene (P(VDF-TrFE)).

Suitable inorganic ferroelectric component for use in the present invention is selected from the group consisting of barium titanium oxide (BTO), lead zirconium titanate (PZT), potassium sodium niobate (KNN) and mixtures thereof.

Preferred ferroelectric component is selected from the group consisting of polyvinylidene difluoride trifluoroethylene (P(VDF-TrFE)), barium titanium oxide (BTO), lead zirconium oxide (PZT) and mixtures thereof.

Suitable commercially available ferroelectric components to be used in the present invention are for example PZT from T & Partners Praha and PVDF Kynar 740 from Arkema.

A ferroelectric adhesive composition according to the present invention comprises a ferroelectric component from 5 % to 85 % by weight of the total weight of the composition, preferably from 7 % to 80 %, and more preferably from 10 % to 78 %.

If the quantity of the ferroelectric component is too high, the adhesion properties of the ferroelectric adhesive composition will decrease. On the other hand too low quantity of the ferroelectric component will lead to poor ferroelectric response or no ferroelectric response at all.

### Solvent

A ferroelectric adhesive composition according present invention may further comprise a solvent. A wide variety of known organic solvents can be used in the present invention. Suitable solvent for use in the present invention can be selected on the basis of the solubility of the fluoropolymer and in some occasions on the basis of the solubility of the adhesive matrix to be used and the manner in which the adhesive composition is to be applied to a substrate. As regards the manner in which the adhesive composition is applied to a substrate, particularly the viscosity of the composition is of importance. One of the factors influencing the viscosity is the solvent. Further, the compatibility of the substrate to which the adhesive is to be applied, with the solvent plays a part.

In a highly preferred embodiment, the ferroelectric adhesive composition comprises solvent in addition to a ferroelectric component and an adhesive matrix.

Suitable solvent for use in the present invention can be selected from the group consisting of alcohols, ketones, esters, glycol esters, glycol ethers, ethers, amides, organosulfur compounds and mixtures thereof.

Preferably, said solvent is selected from the group consisting of acetone, amyl acetate, ethyl 3-ethoxypropionate (EEP, Eastman), diethyl glycol, monoethyl ether, diethylene glycol dimethylene ether, carbitol, carbitol acetate, butyl carbitol, methyl ethyl ketone (MEK), cyclohexanone, diethylene glycol monoethyl ether acetate, ethylene glycol monobutyl ether acetate, ethylene glycol monobutyl ether, dipropylene glycol monomethyl ether, dipropylene glycol dimethyl ether, mixture of dimethyl glutarate and dimethyl succinate (DBE-9), N,N-dimethylformamide, dimethylacetamide, dimethylsulfoxide, water, ethanol and mixtures thereof. More preferably said solvent is selected from the group consisting of acetone, mixture of dimethyl glutarate and dimethyl succinate (DBE-9), methylethyl ketone (MEK) and mixtures thereof.

Fluoropolymers forming a ferroelectric component are very inert, and therefore, hard to dissolve. Preferred solvents provide best solubility, and therefore, provide improved homogeneity for the ferroelectric adhesive composition.

Suitable commercially available solvent to be used in the present invention is for example DBE-9 from Sigma-Aldrich.

A ferroelectric adhesive composition according to the present invention comprises a solvent from 30 % to 90 % by weight of the total weight of the composition, preferably from 50 % to 90%, more preferably from 55 % to 85%.

Ideal quantity of the solvent in the ferroelectric adhesive composition according to the present invention depends on the application. Although, if the solvent quantity is too high, the solid content of the composition is too low and this may cause that bondline may be too thin, and that the coverage is not sufficient enough. And on the other hand if the solvent quantity is too low, this will have negative impact on composition formation and homogenous film formation.

### Initiator

A ferroelectric adhesive composition according present invention may further comprise an initiator. The skilled person is able to determine when the initiator is required or needed in the ferroelectric adhesive composition according to the present invention, mainly when resin polymerization is needed. For example an initiator is used when the adhesive matrix comprises (meth)acrylates.

A wide variety of known initiators can be used in the present invention. Suitable initiator for use in the present invention can be selected on the basis of the compatibility with the adhesive matrix used.

Suitable initiators for use in the present invention are for example selected from the group consisting of bezoyl peroxide (BPO), dicumyl peroxide (DCP), tert-butylperoxy(2-ethylhexyl)-carbonate (TBPEHC), 2-hydroxy-2-methylpropiophenone (2-H-2-MPPh) and mixtures thereof.

Suitable commercially available initiators for use in the present invention are for example tert-butylperoxy(2-ethylhexyl)-carbonate (TBPEHC) from United Initiators and BPO from Alfa Aesar.

When the initiator is present in the ferroelectric adhesive composition, said composition comprises an initiator preferably from 0.01 % to 5 % by weight of the total weight of the composition, preferably from 0.03 % to 1 %, more preferably from 0.05 % to 0.7 %.

Ideal quantity of the initiator in the ferroelectric adhesive composition according to the present invention depends on the adhesive matrix. Although, if the initiator quantity is too high, it prevents the polymeric network formation of the ferroelectric material, and therefore, mainly decreases the ferroelectric response.

### Curing agent

A ferroelectric adhesive composition according present invention may further comprise a curing agent. If curing agent is required, its selection is dependent on the polymer chemistry used and the processing conditions employed. The skilled person is able to determine when the curing agent is required or needed in the ferroelectric adhesive composition according to the present invention. For example a curing agent is used when the adhesive matrix comprises epoxy resin.

It is known to use amines such as aliphatic or aromatic amines for the curing of epoxy resins as shown, for example in US 4,139,524 and US 4,162,358. There is significant technical literature on this subject as illustrated, for example by a technical brochure entitled "Jeffamine® Polyoxypropyleneamines", Copyright 1978 by Jefferson Chemical Company, Inc. Becker et al. US 3,847,726 discloses sheet metal laminates wherein the binder is an epoxide formed by curing an epoxy resin with a multi-component curing mixture, one component of which is a Mannich Condensate of polyoxypropylene amine, phenol and formaldehyde.

Suitable curing agents for use in the present invention are for example selected from the group consisting of polypropylene glycol 130 bis(2-aminopropylether), dicyandiamide, 1,6-diaminohexane, 1,8-diaminooctane, and mixtures thereof.

Suitable commercially available curing agent to be used in the present invention is for example Jeffamine D-230 from Huntsman Chemicals.

To obtain optimum properties with epoxide-reactive curing agents (the amines), it is desirable to react the epoxy based adhesive matrix and the curing agent at approximately stoichiometric quantities. The amount of curing agent that is employed in curing polyepoxide compositions will depend on the amine equivalent weight of the curing agent employed. The total number of equivalents of amine group is preferably from 0.8 to 1.2 times the number of epoxide equivalents present in the curable epoxy resin composition with a stoichiometric amount being most preferred.

When the curing agent is present in the ferroelectric adhesive composition comprises a curing agent preferably from 0.5 % to 30 % by weight of the total weight of the composition, preferably from 1 % to 20 %, more preferably from 1 % to 8 %.

### Optional ingredients

In addition to above mentioned ingredients a ferroelectric adhesive composition according to the present invention may further comprise additional ingredients. Additional ingredients may be included in the ferroelectric adhesive composition to provide desired properties. Various additives typically used in the adhesive compositions, and which may be used in the ferroelectric adhesive compositions according to the present invention include surface active agents, surfactants, wetting agents, antioxidants, thixotropy agents, reinforcement fibers, silane functional perfluoroether, phosphate functional perfluoroether, titanates, waxes, phenol formaldehyde, air release agents, flow additives, adhesion promoters, rheology modifiers, and spacer beads. The optional ingredients are specifically chosen to obtain the desired balance of properties for the use of the binders utilized in the ferroelectric adhesive compositions according to the present invention.

When present, the ferroelectric adhesive composition may comprise optional ingredients up to about 10 % by weight of the total weight of the composition.

Preferably, the ferroelectric adhesive composition according to the present invention has a permanent remnant polarisation value (Pr) equal or greater than 1.0 µC/cm² measured according to the test method described in the examples section, preferably equal or greater than 1.4 µC/cm². In highly preferred embodiment, the permanent remnant polarisation value (Pr) is from 1.5 µC/cm² to 15 µC/cm², more preferably from 1.5 µC/cm² to 7.0 µC/cm².

Preferably, the ferroelectric adhesive composition according to the present invention has a piezoelectric strain coefficient d₃₃ equal or greater than 3.0 pC/N measured according to the test method described in the examples section, preferably equal or greater than 3.5 pC/N. In highly preferred embodiment, d₃₃ coefficient is from 3.9 pC/N to 25 pC/N, more preferably from 3.9 pC/N to 20 pC/N.

Preferably, the ferroelectric adhesive composition according to the present invention has a solid content from 25 % to 100 %. In some embodiments the solid content may be 40 % and in some embodiments the solid content may be close to 75 %.

Ideal solid content provides ideal coverage for the substrate and provides ideal film thickness. Furthermore, ideal solid content has also positive impact on ferroelectric response.

The ferroelectric adhesive composition according to the present invention is in the form of a paste, however, it also may be in the form of an ink, film, a laminate, a tape or hotmelt, preferably the composition is in the form of a paste.

The ferroelectric adhesive composition according to the present invention can be prepared in several ways of mixing all ingredients together.

In one embodiment, the preparation of the ferroelectric adhesive composition according to the present invention comprises following steps:
1) dispersing a ferroelectric component into an adhesive matrix; and
2) adding any optional ingredients and mixing with speed mixer till homogenous mixture is formed.

In another embodiment the preparation of the ferroelectric adhesive composition according to the present invention comprises following steps:
1) dissolving a ferroelectric component into a solvent;
2) dissolving the adhesive matrix into the solution of step 1; and
3) adding any optional ingredients and mixing with speed mixer till homogenous mixture is formed.

The ferroelectric adhesive composition according to the present invention can be used as a structural adhesive.

By the term structural adhesive is meant herein an adhesive, which is relatively strong adhesive that is normally used below its glass transition temperature, such an adhesive can carry significant stresses, and lend itself to structural applications, wherein the adhesive plays as a part of the physical structure of joined surfaces.

The ferroelectric adhesive composition according to the present invention is a structural adhesive, and is therefore, literally a part of the structure of assemblies, where it is used as an adhesive. The ferroelectric adhesive composition according to the present invention is designed to meet performance specifications for the specific requirements of the assembly. Which is an often critical issue in bonding, and is extremely important in ensuring structural integrity.

In one embodiment, the application of the ferroelectric adhesive composition according to the present invention onto the surface of the conductive element comprises following steps of:
1) applying the ferroelectric adhesive composition according to the present invention onto the surface of conductive element;
2) evaporating the solvent (if present);
3) curing the adhesive composition;
4) annealing; and
5) poling.

In some embodiments, steps 2 and 3 can be done simultaneously. And in some other embodiments steps 2, 3 and 4 can be done simultaneously.

In another embodiment, the application of the ferroelectric adhesive composition according to the present invention onto the surface of the conductive element comprises following steps of:
1) applying the ferroelectric adhesive composition according to the present invention onto the surface of conductive element;
2) evaporating the solvent (if present);
3) applying second conductive element top of the ferroelectric adhesive layer;
4) curing the adhesive composition;
5) annealing; and
6) poling.

The ferroelectric adhesive composition according to the present invention can be applied onto a surface of a substrate (preferably conductive element) by various techniques. Suitable non-limiting techniques for use herein are for example roll printing, bar coating, roller coating and dispensing.

The evaporation of the solvent (if present) can be done at room temperature or by applying a heat.

The annealing can be done at various temperatures and for various periods of time. For example from 100 °C to 140 °C and for 1 hour to 24 hours. The skilled person would know how to adjust the temperature and time to achieve desired results.

The poling is done for at least 60 seconds.

Non-limiting examples of suitable conductive elements to be used herein are any conductive materials or materials having conductive surface, for example metals, metal coated substrates such as silver ink coated substrate (PET for example), metallised substrates having for example gold sputtered on them.

The ferroelectric adhesive composition according to the present invention can be used as a sensor, an emitter or as a generator in energy harvester.

Suitable sensors can be for example pressure sensors and suitable emitters can be for example acoustic transducers.

A device, such as an emitter, a sensor or a generator for an energy harvester can be provided, wherein said device comprises a ferroelectric adhesive composition according the present invention between two conductive elements.

Said device can be manufactured without the need of gluing the ferroelectric material to a surface of conductive elements with an additional adhesive.

Said device can be manufactured by applying the ferroelectric adhesive composition according to the present invention onto the surface of the conductive element comprising following steps of 1) applying the ferroelectric adhesive composition according to the present invention onto the surface of conductive element, 2) evaporating the solvent (if present), 3) applying second conductive element top of the ferroelectric adhesive layer, 4) curing the adhesive composition; 5) annealing and 6) poling.

In one preferred embodiment the ferroelectric adhesive composition according to the present invention comprises from 3 to 30 % of an adhesive matrix, from 7 to 80 % of a ferroelectric component, wherein all weight percentages are based on weight of the total weight of the composition, and wherein said ferroelectric component is in a ferroelectric phase.

In another preferred embodiment the ferroelectric adhesive composition according to the present invention comprises from 4 to 28 % of an adhesive matrix, from 10 to 78 % of a ferroelectric component, wherein all weight percentages are based on weight of the total weight of the composition, and wherein said ferroelectric component is in a ferroelectric phase.

In another preferred embodiment the ferroelectric adhesive composition according to the present invention comprises from 3 to 30 % of an adhesive matrix, from 7 to 80 % of a ferroelectric component and a solvent from 30 % to 90%, wherein all weight percentages are based on weight of the total weight of the composition, and wherein said ferroelectric component is in a ferroelectric phase.

In another preferred embodiment the ferroelectric adhesive composition according to the present invention comprises from 4 to 28 % of an adhesive matrix, from 10 to 78 % of a ferroelectric component and a solvent from 55 % to 85%, wherein all weight percentages are based on weight of the total weight of the composition, and wherein said ferroelectric component is in a ferroelectric phase.

In another preferred embodiment the ferroelectric adhesive composition according to the present invention comprises from 4 to 28 % of an adhesive matrix, from 10 to 78 % of a ferroelectric component, a solvent from 55 % to 85% and a curing agent from 1% to 8%, wherein all weight percentages are based on weight of the total weight of the composition, and wherein said ferroelectric component is in a ferroelectric phase.

Yet in another preferred embodiment the ferroelectric adhesive composition according to the present invention comprises from 4 to 28 % of an adhesive matrix, from 10 to 78 % of a ferroelectric component, a solvent from 55 % to 85 % and an initiator from 0.03 % to 0.7 %, wherein all weight percentages are based on weight of the total weight of the composition, and wherein said ferroelectric component is in a ferroelectric phase.

The ferroelectric adhesive composition according to the present invention provides high adhesion properties while maintaining the ferroelectric response, due the fact that the morphology of the system is kept constant. Constant morphology is achieved via homogenous dispersion of the ferroelectric component into an adhesive matrix and minimising phase separation.

The ferroelecteric adhesive composition according to the present invention provides good ferroelectric response due compatibility between selected materials.

### Examples

### Composition:

The ferroelectric adhesive compositions in the examples 1 - 16 comprise following adhesive matrixes CN1963 acrylate from Sartomer; Epikote 828 and 232 epoxies from Momentive; DER 331 epoxy from Dow Chemicals, CN104A60 and CN104B80 epoxy-acrylates from Sartomer; and 24-468A bismaleimides from Henkel.

The ferroelectric adhesive compositions in the examples comprise organic ferroelectric components such as P(VDF-TrFE) from Solvay and BTO from Alfa Aesar.

Solvents for these systems comprise acetone, methyl ethyl ketone (MEK from Alfa Aesar), n,n-dimethylformamide (DMF from Alfa Aesar) and DBE-9 (from Sigma-Aldrich).

Initiators used in the examples below include BPO benzoyl peroxide from Alfa Aesar, DCP dicumyl peroxide from Alfa Aesar and TBPEHC tert-butylperoxy(2-ethylhexyl)-carbonate from United Initiators and 2-hydroxy-2-methylpropiophenone from Sigma-Aldrich.

Curing agent used in the examples below include Jeffamine D-230 from Huntsman chemicals.

In order to prepare the ferroelectric adhesive compositions, the ferroelectric component and adhesive matrix are mixed together followed by addition of any optional ingredients used.

In table 1, detailed compositions of the examples 1 - 16 are shown.

**Table 1.**

| **Example** | **Adhesive matrix** | **Ferroelectric material** | **Solvent** | **Initiator** | **Curing agent** |
|---|---|---|---|---|---|
| Example 1 | CN1963 | P(VDF-TrFE) | Acetone | TBPEHC | - |
| | 0.20 g | 0.45 g | 2.55 g | 2.0 mg | |
| Example 2 | CN1963 | P(VDF-TrFE) | Acetone | TBPEHC | - |
| | 0.45 g | 0.45 g | 2.55 g | 4.5 mg | |
| Example 3 | CN1963 | P(VDF-TrFE) | Acetone | TBPEHC | - |
| | 1.05 g | 0.45 g | 2.55 g | 10.5 mg | |
| Example 4 | D.E.R 331 | BTO | - | - | Jeff. D230 |
| | 0.95 g | 3.75 g | | | 0.3 g |
| Example 5 | Epikote 232 | BTO | - | - | Jeff. D230 |
| | 0.95 g | 3.75 g | | | 0.3 g |
| Example 6 | Epikote 232 | P(VDF-TrFE) | Acetone | - | Jeff. D230 |
| | 0.20 g | 0.50 g | 2.80 g | | 0.06 g |
| Example 7 | EP-ACR B80 | P(VDF-TrFE) | Acetone | TBPEHC | - |
| | 0.20 g | 0.50 g | 2.80 g | 2.0 mg | |
| Example 8 | EP-ACR A60 | P(VDF-TrFE) | Acetone | TBPEHC | - |
| | 0.20 g | 0.50 g | 2.80 g | 2.0 mg | |
| Example 9 | BMI 24-468A | P(VDF-TrFE) | Acetone | TBPEHC | - |
| | 0.20 g | 0.45 g | 2.55 g | 2.0 mg | |
| Example 10 comparative | - | P(VDF-TrFE) | Acetone | - | - |
| | | 1.50 g | 8.50 g | | |
| Example 11 comparative | CN1963 | - | - | TBPEHC | - |
| | 3.00 g | | | 30 mg | |
| Example 12 comparative | D.E.R 331 | - | - | - | Jeff. D230 |
| | 0.95 g | | | | 0.30 g |
| Example 13 comparative | Epikote 232 | - | - | - | Jeff. D230 |
| | 0.95 g | | | | 0.30 g |
| Example 14 comparative | EP-ACR B80 | - | - | TBPEHC | - |
| | 0.20 g | | | 2.0 mg | |
| Example 15 comparative | EP-ACR A60 | - | - | TBPEHC | - |
| | 0.20 g | | | 2.0 mg | |
| Example 16 comparative | BMI 24-468A | - | - | TBPEHC | - |
| | 0.20 g | | | 2.0 mg | |

In order to carry out ferroelectric characterization, the films are prepared as follows:
A ferroelectric component is dispersed into an adhesive matrix mixed together and any optional ingredient is added into this mixture. Films are subsequently prepared by bar-coating the solutions with a coating gap of 200µm.

Film casting is made on a conductive substrate (metallized PET), which acts like an electrode for the ferroelectric characterization. After casting, solvent is evaporated at appropriate temperature for appropriate time, details for each specific case can be seen in table 2. No curing step is required for these materials. When required, films are annealed at 130°C for a certain time, depending on the system. Final film thickness is from 5 µm to 60 µm, preferably 20 µm.

After the ferroelectric adhesive film is dried, upper electrodes are placed using a silver containing ink, by metal sputtering or using a conductive piece.

The key parameters for the sample preparation of each example is shown in table 2.

**Table 2.**

| **Example/** | **Solvent evaporation temp. °C** | **Solvent evaporation time min** | **Curing temperature °C** | **Curing time h** | **Annealing temperature °C** | **Annealing time h** | **Film thick-ness µm** |
|---|---|---|---|---|---|---|---|
| Example 1 | 60 °C | 1 min | 130 °C | 6 h | **-** | - | 20 µm |
| Example 2 | 60 °C | 1 min | 130 °C | 6 h | - | - | 20 µm |
| Example 3 | 60 °C | 1 min | 130 °C | 6 h | - | - | 20 µm |
| Example 4 | - | - | 100 °C | 1.5 h | - | - | 60 µm |
| Example 5 | - | - | 100 °C | 1.5 h | - | - | 60 µm |
| Example 6 | RT | 15 min | 100 °C | 1.5 h | 130 °C | 15 h | 20 µm |
| Example 7 | 60 °C | 1 min | 130 °C | 6 h | 130 °C | 15 h | 20 µm |
| Example 8 | 60 °C | 1 min | 100 °C | 6 h | 130 °C | 15 h | 20 µm |
| Example 9 | 60 °C | 1 min | 130 °C | 4 h | 130 °C | 15 h | 20 µm |
| Example 10 comparative | RT | 10 min | - | | 130 °C | 15 h | 10 µm |
| Example 11 comparative | 60 °C | 1 min | 100 °C | 6 h | - | - | 60 µm |
| Example 12 comparative | - | - | 130 °C | 1.5 h | - | - | 60 µm |
| Example 13 comparative | - | - | 100 °C | 1.5 h | - | - | 60 µm |
| Example 14 comparative | 60 °C | 1 min | 130 °C | 6 h | 130 °C | 15 h | 20 µm |
| Example 15 comparative | 60 °C | 1 min | 100 °C | 6 h | 130 °C | 15 h | 20 µm |
| Example 16 comparative | 60 °C | 1 min | 130 °C | 4 h | - | - | 20 µm |

### Ferroelectric characterization of ferroelectric adhesive composition

Ferroelectricity measurements consist on applying two cycles of an alternating external electric field at low frequency (freq.) to the sample. For that purpose, a high voltage AC power supply is needed. The electric field will polarize the sample generating some charge in the material, which is measured with a charge amplifier and visualized in an oscilloscope TDS200. The charge divided by the sample area gives the polarization value for each electric field applied. From this test, remnant polarization (Pr), coercive field (Ec) are measured at a certain frequency.

### Poling of ferroelectric adhesive composition

After performing the ferroelectric characterization, the poling field (E poling) is determined considering it must be above the Ec. The material is then poled under E poling field for at least 60 seconds.

### d₃₃ coefficient measurement of ferroelectric adhesive composition

After poling is carried out, the measurement of the d₃₃ coefficient (piezoelectric strain coefficient) is performed using a Piezo d₃₃-meter PM-3500 (KCF Technologies, Inc). A low frequency oscillatory force (0.25N and 110 Hz) is applied to the sample and to a ceramic reference, generating some charge in both materials due to the piezoelectric effect. Knowing the d₃₃ of the reference, the d₃₃ of the sample is obtained by direct comparison

### Adhesion properties of the ferroelectric adhesives

Adhesion properties are measured for the ferroelectric adhesives according to the adhesive characterisation ISO4587. A stainless steel lap shear specimen is coated with the ferroelectric adhesive composition, and the solvent, if present, is removed following the solvent evaporation. Subsequently, another lap shear specimen is mounted on top of the coated one, and is clamped by using clips. The setup is then placed in an oven for thermal curing of the adhesive resin. The tensile strength tests are carried out with an Instron 3366.

The results are summarised in table 3.

**Table 3.**

| **Example** | **Pr µC/cm²** | **Ec V/µm** | **Frequency Hz** | **d₃₃ pC/N** | **E poling V/µm** | **Lap shear strength MPa** |
|---|---|---|---|---|---|---|
| Example 1 | 5.4 | 55 | 0.1 | 18 | 120 | 9.33 |
| Example 2 | 4.9 | 80 | 0.1 | 10.5 | 120 | 6.91 |
| Example 3 | 3.4 | 125 | 0.5 | 3.9 | 140 | 8.01 |
| Example 4 | 6.4 | 55 | 1 | 9 | 70 | 11.79 |
| Example 5 | 2 | 40 | 1 | 12 | 50 | 8.30 |
| Example 6 | 2.5 | 100 | 1 | 10.5 | 160 | 9.86 |
| Example 7 | 7 | 110 | 1 | 13.6 | 170 | 7.18 |
| Example 8 | 7 | 115 | 1 | 10.2 | 175 | 7.62 |
| Example 9 | 4.5 | 68 | 1 | 16.5 | 150 | 6.74 |
| Example 10 comparative | 7.7 | 50 | 0.1 | 22 | 70 | 0 |
| Example 11 comparative | - | - | 1 | 1 | 150 | 4.76 |
| Example 12 comparative | - | - | 1 | 1 | - | 16.05 |
| Example 13 comparative | - | - | 1 | - | - | 13.77 |
| Example 14 comparative | - | - | 1 | 1 | - | 5.16 |
| Example 15 comparative | - | - | 1 | 1 | - | 5.25 |
| Example 16 comparative | - | - | 1 | 1 | - | 4.89 |

| | | | | | | |
|---|---|---|---|---|---|---|
| Note - for all the materials with "-" on the Pr column, Pr = 0 which means they are dielectric materials instead of ferroelectric, and all the other ferroelectric parameters have no meaning. | | | | | | |

Incorporation of ferroelectric components into the adhesive matrix clearly provides ferroelectric response into these adhesive matrixes. As all the control examples (adhesive matrix only) show a clear dielectric behaviour instead of ferroelectric one. Furthermore, in some of the adhesive matrixes the presence of ferroelectric polymers have proven to improve the mechanical resistance of these structural adhesives, probably due to the good compatibility between fluoropolymers and acrylate containing polymers.

### Composition:

The ferroelectric adhesive compositions in the examples 17 - 26 comprise the following adhesive matrixes, Superglue3 from Henkel and Beta-methoxyethyl Cyanoacrylate (BMECA), n-Butyl Cyanoacrylate (nBuCA), 2-Octyl Cyanoacrylate (2-OCA) from AFINITICA.

The ferroelectric adhesive compositions in the examples 17 - 26 comprise organic ferroelectric components such as P(VDF-TrFE) from Solvay. Solvents for these systems comprise acetone and methyl ethyl ketone (MEK from Alfa Aesar).

In table 4, detailed compositions of the examples 17 - 26 are shown.

**Table 4.**

| **Example** | **Adhesive matrix** | **Ferroelectric material** | **Solvent** |
|---|---|---|---|
| Example 17 comparative | Superglue3 | | MEK |
| | 1.5 g | | 4.5 g |
| Example 18 comparative | Superglue3 | | Acetone |
| | 1.5 g | | 4.5 g |
| Example 19 comparative | Superglue3 | | |
| | 1.5 g | | |
| Example 20 Example 21 | Superglue3 | P(VDF-TrFE) | MEK |
| | 0.19 g | 0.75 g | 2.25 g |
| Example 22 Example 23 | Superglue3 | P(VDF-TrFE) | Acetone |
| | 0.19 g | 0.75 g | 2.25 g |
| Example 24 | BMECA | P(VDF-TrFE) | MEK |
| | 0.21 g | 0.50 g | 1.50 g |
| Example 25 | nBuCA | P(VDF-TrFE) | MEK |
| | 0.21 g | 0.50 g | 1.50 g |
| Example 26 | 2-OCA | P(VDF-TrFE) | MEK |
| | 0.21 g | 0.50 g | 1.50 g |

In order to carry out the ferroelectric characterization, the films were prepared as follows: The ferroelectric component was dispersed into the solvent and the adhesive matrix was then added. The materials were mixed together. Subsequently, films were prepared by bar-coating the solutions with a coating gap of 250 µm.

Film casting was made on a conductive substrate (metallized PET), which acts like an electrode for the ferroelectric characterization. After casting, solvent was evaporated at appropriate temperature for appropriate time, details for each specific case can be seen in table 5. Films were annealed at 130°C for 15 hours. Final film thickness varies between 9 µm to 25 µm. Afterwards, upper electrodes were deposited over the film by metal sputtering.

The key parameters for the sample preparation of each example are shown in table 5.

**Table 5.**

| **Example/** | **Solvent evaporation temperature** | **Solvent evaporation time** | **Curing temperature** | **Curing time** | **Film thickness** |
|---|---|---|---|---|---|
| Example 17 comparative | RT | 5 min | 130°C | 1 hour | 24 µm |
| Example 18 comparative | RT | 10 min | 130°C | 1 hour | 25 µm |
| Example 19 comparative | RT | 24 hour | 40°C | 3 hour | 9 µm |
| Example 20 | RT | 10 min | 130°C | 1 hour | 17 µm |
| Example 21 | 40°C | 5 min | 130°C | 1 hour | 17 µm |
| Example 22 | RT | 10 min | 130°C | 1 hour | 16 µm |
| Example 23 | 40°C | 5 min | 130°C | 1 hour | 17 µm |
| Example 24 | RT | 5 min | 130°C | 1 hour | 20 µm |
| Example 25 | RT | 5 min | 130°C | 1 hour | 20 µm |
| Example 26 | RT | 5 min | 130°C | 1 hour | 19 µm |

### Ferroelectric characterization of ferroelectric adhesive composition

Ferroelectricity measurements are conducted as described above for the examples 1 - 16. Poling of ferroelectric adhesive composition is conducted as described above for the examples 1 - 16. d₃₃ coefficient measurement of the ferroelectric adhesive composition is conducted as described above for the examples 1 - 16. Adhesion properties of the ferroelectric adhesives are measured as described above for the examples 1 - 16. The results are summarised in table 6.

**Table 6.**

| **Example** | **Pr µC/cm²** | **Ec V/µm** | **Frequency Hz** | **d₃₃ pC/N** | **E poling V/µm** | **Lap shear strength MPa** |
|---|---|---|---|---|---|---|
| Example 17 comparative | - | - | 1 | - | - | 2.6 |
| Example 18 comparative | - | - | 1 | - | - | 3.1 |
| Example 19 comparative | - | - | 1 | - | - | 4.9 |
| Example 20 | 8 | 83 | 1 | 20 | 175 | 3.4 |
| Example 21 | 6.8 | 72 | 1 | 22 | 175 | 4.0 |
| Example 22 | 7.4 | 94 | 1 | 20 | 190 | 3.3 |
| Example 23 | 7.4 | 100 | 1 | 21 | 175 | 4.0 |
| Example 24 | 7 | 68 | 1 | 20 | 150 | 3.5 |
| Example 25 | 7 | 68 | 1 | 19 | 150 | 4.2 |
| Example 26 | 8.15 | 70 | 1 | 19 | 160 | 2.0 |

| | | | | | | |
|---|---|---|---|---|---|---|
| Note - for all the materials with "-" on the Pr column, Pr = 0 which means they are dielectric materials instead of ferroelectric, and all the other ferroelectric parameters have no meaning. | | | | | | |

Incorporation of ferroelectric components into the adhesive matrix clearly provides ferroelectric response into these adhesive matrixes. As all the control examples (adhesive matrix only) show a clear dielectric behaviour instead of ferroelectric one.

## Claims

1. A ferroelectric adhesive composition comprising
a) from 3 % to 30 % of an adhesive matrix;
b) from 5 to 85 % of a ferroelectric component; and
c) from 30 % to 90 % of a solvent,
wherein all weight percentages are based on weight of the total weight of the composition, and wherein said ferroelectric component is in a ferroelectric phase.

2. A ferroelectric adhesive composition according to claim 1, wherein said adhesive matrix is selected from the group consisting of hotmelt adhesives, thermoset adhesives, thermoplastics, one or two component polyurethanes, one or two component polyepoxides, one or two component silicone polymers, (meth)acrylates, cyanoacrylates and mixtures thereof.

3. A ferroelectric adhesive composition according to claim 1 or 2, wherein said ferroelectric component is selected from the group consisting of barium titanium oxide (BTO), lead zirconium titanate (PZT), potassium sodium niobate (KNN), polyvinylidene difluoride (PVDF), polyvinylidene difluoride trifluoroethylene (P(VDF-TrFE)), polyvinylidene difluoride hexafluoropropylene (P(VDF-HFP)), polyvinylidene difluoride trifluoroethylene chlorofluoroethylene (P(VDF-TrFE-CFE)) 2-methylbenzimidazole, diisopropylammonium chloride, diisopropylammonium bromide, croconic acid, TTF-PMDI salts and mixtures thereof, preferably said ferroelectric component is selected from the group consisting of barium titanium oxide (BTO), lead zirconate titanate (PZT), polyvinylidene difluoride trifluoroethylene (P(VDF-TrFE)) and mixtures thereof.

4. A ferroelectric adhesive composition according any of claims 1 to 3, wherein the composition comprises an adhesive matrix preferably from 4 % to 28% by weight of the total weight of the composition.

5. A ferroelectric adhesive composition according any of claims 1 to 4, wherein the composition comprises a ferroelectric component preferably from 7 % to 80 % by weight of the total weight of the composition, more preferably from 10 % to 78%.

6. A ferroelectric adhesive composition according to any of claims 1 to 5, wherein said solvent is selected from the group consisting of alcohols, ketones, esters, glycol esters, glycol ethers, ethers, amides, organosulfur compounds and mixtures thereof.

7. A ferroelectric adhesive composition according claim 1, wherein the composition comprises a solvent from 50 % to 90% by weight of the total weight of the composition, preferably from 55 % to 85%.

8. Use of a ferroelectric adhesive composition according to any of claims 1 to 7 as a structural adhesive.

9. Use of a ferroelectric adhesive composition according to claim 8 as a sensor, an emitter or as a generator in an energy harvester.

10. A device comprising a ferroelectric adhesive composition according any of claims 1 to 7 between two conductive elements.

## Patentansprüche

1. Ferroelektrische Klebstoffzusammensetzung, umfassend:
a) 3 % bis 30 % einer Klebstoffmatrix;
b) 5 bis 85 % einer ferroelektrischen Komponente; und
c) 30 % bis 90 % eines Lösungsmittels,
wobei alle Gewichtsprozente auf das Gewicht des Gesamtgewichts der Zusammensetzung bezogen sind und wobei die ferroelektrische Komponente in einer ferroelektrischen Phase ist.

2. Ferroelektrische Klebstoffzusammensetzung nach Anspruch 1, wobei die Klebstoffmatrix aus der Gruppe bestehend aus Heißschmelzklebstoffen, Duroplast-Klebstoffen, Thermoplasten, Polyurethanen mit einer oder zwei Komponenten, Polyepoxiden mit einer oder zwei Komponenten, Silikonpolymeren mit einer oder zwei Komponenten, (Meth-)Acrylaten, Cyanacrylaten und Mischungen davon ausgewählt ist.

3. Ferroelektrische Klebstoffzusammensetzung nach Anspruch 1 oder 2, wobei die ferroelektrische Komponente aus der Gruppe bestehend aus Bariumtitanoxid (BTO), Bleizirkoniumtitanat (PZT), Kaliumnatriumniobat (KNN), Polyvinylidendifluorid (PVDF), Polyvinylidendifluoridtrifluorethylen (P(VDF-TrFE)), Polyvinylidendifluoridhexafluorpropylen (P(VDF-HFP)), Polyvinylidendifluoridtrifluorethylenchlorfluorethylen (P(VDF-TrFE-CFE)) 2-Methylbenzimidazol, Diisopropylammoniumchlorid, Diisopropylammoniumbromid, Krokonsäure, TTF-PMDI-Salzen und Mischungen davon ausgewählt ist, wobei die ferroelektrische Komponente bevorzugt aus der Gruppe bestehend aus Bariumtitanoxid (BTO), Bleizirkoniumtitanat (PZT), Polyvinylidendifluoridtrifluorethylen (P(VDF-TrFE)) und Mischungen davon ausgewählt ist.

4. Ferroelektrische Klebstoffzusammensetzung nach einem der Ansprüche 1 bis 3, wobei die Zusammensetzung eine Klebstoffmatrix, bevorzugt von 4 Gew.-% bis Gew.-28 % des Gesamtgewichts der Zusammensetzung, umfasst.

5. Ferroelektrische Klebstoffzusammensetzung nach einem der Ansprüche 1 bis 4, wobei die Zusammensetzung eine ferroelektrische Komponente, bevorzugt von 7 Gew.-% bis 80 Gew.-% des Gesamtgewichts der Zusammensetzung, stärker bevorzugt von 10 % bis 78 %, umfasst.

6. Ferroelektrische Klebstoffzusammensetzung nach einem der Ansprüche 1 bis 5, wobei das Lösungsmittel aus der Gruppe bestehend aus Alkoholen, Ketonen, Estern, Glykolestern, Glykolethern, Ethern, Amiden, schwefelorganischen Verbindungen und Mischungen daraus ausgewählt ist.

7. Ferroelektrische Klebstoffzusammensetzung nach Anspruch 1, wobei die Zusammensetzung ein Lösungsmittel von 50 Gew.-% bis 90 Gew.-% des Gesamtgewichts der Zusammensetzung, bevorzugt von 55 % bis 85 %, umfasst.

8. Verwendung einer ferroelektrischen Klebstoffzusammensetzung nach einem der Ansprüche 1 bis 7 als ein Montageklebstoff.

9. Verwendung einer ferroelektrischen Klebstoffzusammensetzung nach Anspruch 8 als ein Sensor, ein Emitter oder als ein Generator in einer Energieernteeinrichtung.

10. Vorrichtung, umfassend eine ferroelektrische Klebstoffzusammensetzung nach einem der Ansprüche 1 bis 7 zwischen zwei leitfähigen Elementen.

## Revendications

1. Composition d'adhésif ferroélectrique, comprenant :
a) de 3 à 30 % d'une matrice adhésive ;
b) de 5 à 85 % d'un constituant ferroélectrique ; et
c) de 30 à 90 % d'un solvant,
l'ensemble des pourcentages en poids étant basés sur le poids total de la composition, et ledit constituant ferroélectrique étant dans une phase ferroélectrique.

2. Composition d'adhésif ferroélectrique selon la revendication 1, dans laquelle ladite matrice adhésive est choisie dans l'ensemble constitué d'adhésifs, d'adhésifs thermodurcis, de thermoplastiques, d'un ou deux polyuréthanes de constituant, d'un ou deux polyépoxydes de constituant, d'un ou deux polymères de silicone de constituant, de (méth)acrylates, de cyanoacrylates et de leurs mélanges.

3. Composition d'adhésif ferroélectrique selon la revendication 1 ou 2, dans laquelle ledit constituant ferroélectrique est choisi dans l'ensemble constitué d'oxyde de baryum titane (BTO), de titanate de plomb zirconium (PZT), de niobate de potassium sodium (KNN), de poly(difluorure de vinylidène) (PVDF), de poly(difluorure de vinylidène trifluoroéthylène) (P(VDF-TrFE)), de poly(difluorure de vinylidène hexafluoropropylène) (P(VDF-HFP)), de poly(difluorure de vinylidène trifluoroéthylène chlorofluoroéthylène) (P(VDF-TrFE-CFE)) 2-méthylbenzimidazole, chlorure de diisopropylammonium, bromure de diisopropylammonium, acide croconique, sels de TTF-PMDI et leurs mélanges, où de préférence ledit constituant ferroélectrique est choisi dans l'ensemble constitué d'oxyde de baryum titane (BTO), de zirconate titanate de plomb (PZT), de poly(difluorure de vinylidène trifluoroéthylène) (P(VDF-TrFE) et de leurs mélanges.

4. Composition d'adhésif ferroélectrique selon l'une quelconque des revendications 1 à 3, la composition comprenant une matrice d'adhésif représentant de préférence de 4 % à 28 % en poids du poids total de la composition.

5. Composition d'adhésif ferroélectrique selon l'une quelconque des revendications 1 à 4, la composition comprenant un constituant ferroélectrique représentant de préférence de 7 à 80 % en poids du poids total de la composition, ou mieux de 10 % à 78 %.

6. Composition d'adhésif ferroélectrique selon l'une quelconque des revendications 1 à 5, dans laquelle ledit solvant est choisi dans l'ensemble constitué d'alcools, de cétones, d'esters, de glycol esters, de glycol éthers, d'éthers, d'amides, de composés organosulfurés et de leurs mélanges.

7. Composition d'adhésif ferroélectrique selon la revendication 1, la composition comprenant un solvant représentant de 50 % à 90 % en poids du poids total de la composition, de préférence de 55 à 85 %.

8. Utilisation d'une composition d'adhésif ferroélectrique selon l'une quelconque des revendications 1 à 7 en tant qu'adhésif de structure.

9. Utilisation d'une composition d'adhésif ferroélectrique selon la revendication 8 en tant que capteur, en tant qu'émetteur ou en tant que générateur dans un récupérateur d'énergie.

10. Dispositif comprenant une composition d'adhésif ferroélectrique selon l'une quelconque des revendications 1 à 7 entre deux éléments conducteurs.
